# FASCICULE DE BREVET EUROPEEN

(11) **EP 4 064 479 B1**
(45) Date de publication et mention de la délivrance du brevet: **13.12.2023**
(21) Numéro de dépôt: 22164364.6
(22) Date de dépôt: 25.03.2022
(51) Int. Cl.: H02B 1/36, H02B 1/34, H02B 1/01

(54) **CAISSON DE SUPPORTAGE, ARMOIRE ÉLECTRIQUE DE RACCORDEMENT COMPRENANT UN TEL CAISSON DE SUPPORTAGE ET PROCÉDÉ D ASSEMBLAGE D'UNE TELLE ARMOIRE ÉLECTRIQUE**
TRÄGERKASTEN, ANSCHLUSSSCHRANK MIT EINEM SOLCHEN TRÄGERKASTEN UND VERFAHREN ZUM ZUSAMMENBAU EINES SOLCHEN ANSCHLUSSSCHRANKS
SUPPORT BOX, ELECTRICAL CONNECTION CABINET COMPRISING SUCH A SUPPORT BOX AND METHOD FOR ASSEMBLING SUCH AN ELECTRICAL CABINET

(30) Priorité: 26.03.2021 FR 2103095
(43) Date de publication de la demande: 28.09.2022
(73) Titulaire: Schneider Electric Industries SAS, 92500 Rueil-Malmaison (FR)
(72) Inventeur: LINARES, Louis, 38660 LA TERRASSE (FR); MORESCO, Jean-Claude, 38130 ECHIROLLES (FR)
(74) Mandataire: Lavoix

(56) Documents cités:
- EP-B1- 2 277 248
- WO-A1-2019/192689
- WO-A2-03/101161
- DE-A1- 1 515 561
- RU-C1- 2 741 065
- US-B1- 6 398 041

## Description

La présente invention concerne un caisson de supportage pour une armoire électrique de raccordement, une armoire électrique de raccordement comprenant un tel caisson de supportage et un procédé d'assemblage d'une telle armoire électrique.

Dans le domaine des armoires électriques industrielles, il est connu d'installer dans une armoire électrique de raccordement un ou plusieurs tiroirs de contrôle-commande. Ces tiroirs de contrôle-commande comprennent des éléments électroniques, et notamment des disjoncteurs, qui permettent de raccorder l'armoire électrique à des charges électriques et de fournir une puissance électrique à ces charges électriques.

Pour cela, un tiroir de contrôle-commande est raccordé, d'une part, à une source d'électricité, comme par exemple un jeu de barres, par l'intermédiaire de connecteurs amont, et, d'autre part, à une charge électrique, par l'intermédiaire de connecteurs aval.

Il est également connu que de tels tiroirs de contrôle-commande peuvent être mobiles dans une armoire électrique de raccordement entre une position de fonctionnement dans laquelle les connecteurs amont et aval sont raccordés respectivement à la source d'électricité et à la charge électrique, et une position débrochée dans laquelle les connecteurs amont et aval ne sont pas raccordés.

Généralement, cette mobilité est assurée en faisant rouler un tiroir sur une plaque de support fixée directement à une ossature de l'armoire électrique.

Une telle solution présente l'inconvénient d'être imprécise, car l'ossature d'une armoire électrique risque de se déformer, ce qui implique que le positionnement d'une plaque de support est peu précis, car dépendant des déformations de l'ossature. Ainsi, le positionnement d'un tiroir de contrôle-commande à l'intérieur d'une armoire électrique ne peut pas être réalisé avec précision. Ceci est préjudiciable au bon fonctionnement des connecteurs amont et aval.

Pour compenser cette imprécision dans le positionnement d'un tiroir de contrôle-commande, il est connu de raccorder un tel tiroir à la source d'électricité et à la charge électrique à l'aide de connecteurs souples. Cependant, de tels connecteurs souples présentent l'inconvénient d'être encombrants et d'empêcher l'optimisation de l'espace utilisé par le tiroir de contrôle-commande et par les connecteurs.

Pour compenser cette imprécision dans le positionnement d'un tiroir de contrôle-commande, il est également connu de raccorder un tel tiroir à la source d'électricité et à la charge électrique à l'aide de connecteurs rigides configurés pour accepter des variations importantes dans le positionnement du tiroir. Cependant, de tels connecteurs sont onéreux et sont également encombrants.

Le document WO-A-2019/192689 décrit une armoire comprenant des compartiments adaptés chacun pour recevoir un module embrochable. Ces compartiments sont formés par une base, un toit, au moins une paroi latérale et un fond, et sont assemblés à une ossature de l'armoire par vissage. Ces compartiments ne sont pas adaptés pour être installés dans une armoire dont l'ossature serait déformée, car ils ne permettent pas de compenser les défauts de l'ossature. Lorsque ces compartiments sont installés dans une armoire dont l'ossature est déformée, les modules peuvent devenir complexe ou impossible à insérer et retirer des compartiments.

C'est à ces inconvénients qu'entend plus particulièrement remédier l'invention en proposant un dispositif amélioré de fixation d'au moins un tiroir de contrôle-commande dans une armoire électrique de raccordement.

La présente invention concerne un caisson de supportage d'éléments fonctionnels au sein de l'ossature d'une armoire électrique de raccordement, ce caisson comprenant :
- au moins une paire de rails de guidage en translation d'un tiroir de contrôle-commande constituant un élément fonctionnel ;
- une armature parallélépipédique comprenant :
   ∘ deux plaques horizontales en configuration montée du caisson dans l'ossature ;
   ∘ un fond perpendiculaire aux plaques horizontales et vertical en configuration montée du caisson dans l'ossature ; et
   ∘ deux parois verticales en configuration montée du caisson dans l'ossature et qui supportent chacune un rail de chaque paire de rails,
- des organes de fixation de l'armature sur l'ossature.

Selon l'invention, les organes de fixation de l'armature sur l'ossature de l'armoire électrique comprennent des pattes de fixation élastiquement déformables et monobloc avec les plaques horizontales, les organes de fixation de l'armature sur l'ossature de l'armoire électrique comprennent des pattes de reprise de charge élastiquement déformables, monobloc avec les parois verticales et le caisson de supportage comprend en outre au moins un pion de centrage, configuré pour centrer verticalement le caisson par rapport à un poteau de l'ossature de l'armoire, chaque pion de centrage étant disposé dans un trou de positionnement d'une patte de fixation.

Grâce à l'invention, le caisson de supportage comprend des moyens de guidage d'au moins un tiroir de contrôle-commande dont le positionnement n'est pas contraint par le positionnement de l'ossature de l'armoire électrique de raccordement car le caisson assure un positionnement efficace des éléments fonctionnels, indépendamment d'une éventuelle déformation de l'ossature de l'armoire électrique. En outre, les organes de fixation ainsi que le pion de centrage permettent de compenser efficacement une éventuelle déformation de l'ossature de l'armoire électrique.

Selon des aspects avantageux, mais non obligatoire de l'invention, le caisson de supportage incorpore une ou plusieurs des caractéristiques suivantes, prises isolément ou selon toutes combinaisons techniquement admissibles :
- Chaque plaque de l'armature comprend un voile principal, horizontal en configuration montée du caisson dans l'ossature de l'armoire électrique, et une bordure, perpendiculaire au voile principal et parallèle au fond de l'armature, et le fond de l'armature est fixé aux bordures des plaques.
- Chaque plaque horizontale de l'armature comprend des ergots formant deux guides de positionnement, chaque guide de positionnement étant configuré pour positionner une paroi verticale de l'armature par rapport à la plaque horizontale comprenant ce guide de positionnement.
- Le fond de l'armature comprend au moins deux encoches, chaque encoche étant configurée pour positionner une paroi verticale de l'armature par rapport au fond.

Selon un autre aspect, l'invention concerne également une armoire électrique de raccordement qui comprend au moins :
- une ossature, l'ossature étant de forme globalement parallélépipédique et comprenant des poteaux verticaux ;
- au moins un caisson de supportage tel que décrit ci-dessus ; et
- au moins un élément fonctionnel comprenant au moins un tiroir de contrôle-commande, chaque élément fonctionnel étant monté dans un caisson et chaque tiroir de contrôle-commande étant mobile en translation dans une paire de rails de guidage d'un caisson.

Cette armoire électrique de raccordement induit les mêmes avantages que ceux mentionnés ci-dessus au sujet du caisson de supportage de l'invention.

Avantageusement, les éléments fonctionnels montés dans un caisson de supportage comprennent au moins :
- au moins un tiroir de contrôle-commande,
- une unité de protection, l'unité de protection étant commune à tous les tiroirs de contrôle-commande montés dans le caisson, alimentant en énergie électrique tous les tiroirs de contrôle-commande et protégeant électriquement tous les tiroirs de contrôle-commande, l'unité de protection étant fixée à une paroi verticale de l'armature du caisson et supportant le rail de chaque paire de rails associé à cette paroi verticale,
- un tronçon de bus informatique configuré pour connecter tous les tiroirs de contrôle-commande du caisson à un ordinateur industriel, et
- plusieurs modules de raccordement, notamment autant de modules de raccordement que de tiroirs de contrôle-commande, chaque module de raccordement étant configuré pour raccorder électriquement un tiroir de contrôle-commande à une charge électrique.

Selon un autre aspect, l'invention concerne également un procédé d'assemblage d'une armoire électrique de raccordement qui comprend au moins des phases consistant à :
- assembler un caisson de supportage tel que décrit ci-dessus sur l'ossature d'une colonne, entre des poteaux verticaux ; et
- équiper le caisson, en place dans la colonne, avec des éléments fonctionnels.

Ce procédé d'assemblage induit les mêmes avantages que ceux mentionnés ci-dessus au sujet du caisson de supportage de l'invention.

L'invention sera mieux comprise et d'autres avantages de celle-ci apparaitront plus clairement à la lumière de la description qui va suivre d'un mode de réalisation d'un caisson de supportage, d'une armoire électrique de raccordement et d'un procédé d'assemblage conformes à son principe, donnée uniquement à titre d'exemple et faite en référence aux dessins annexés dans lesquels :
[Fig. 1] La figure 1 est une vue en perspective d'une armoire électrique conforme à l'invention ;
[Fig 2] La figure 2 est une vue en perspective d'une partie de l'ossature de l'armoire électrique de la figure 1 et d'un caisson de supportage conforme à l'invention ;
[Fig 3] La figure 3 est une vue en perspective du caisson de supportage de la figure 2 ;
[Fig 4] La figure 4 est une vue en perspective du caisson de supportage des figures 2 et 3 vu selon un autre angle ;
[Fig 5] La figure 5 est une vue en perspective du caisson de supportage des figures 2 à 4 vu selon un autre angle ;
[Fig 6] La figure 6 est une vue en perspective éclatée du caisson de supportage des figures 2 à 5 ;
[Fig 7] La figure 7 est une vue à plus grande échelle du détail VII à la figure 4 ;
[Fig 8] La figure 8 est une vue en perspective d'une paroi verticale du caisson de supportage des figures 2 à 7 ;
[Fig 9] La figure 9 est une coupe longitudinale et en perspective d'une partie de l'armoire électrique selon le plan IX à la figure 2 ;
[Fig 10] La figure 10 est une vue en perspective d'un pion de centrage utilisé dans l'armoire des figures 1 et 2 ;
[Fig 11] La figure 11 est une vue en perspective de l'ossature d'une deuxième armoire électrique conforme à l'invention, équipée d'un deuxième caisson de supportage conforme à l'invention ; et
[Fig 12] La figure 12 est une vue en perspective du caisson de supportage de la figure 11.

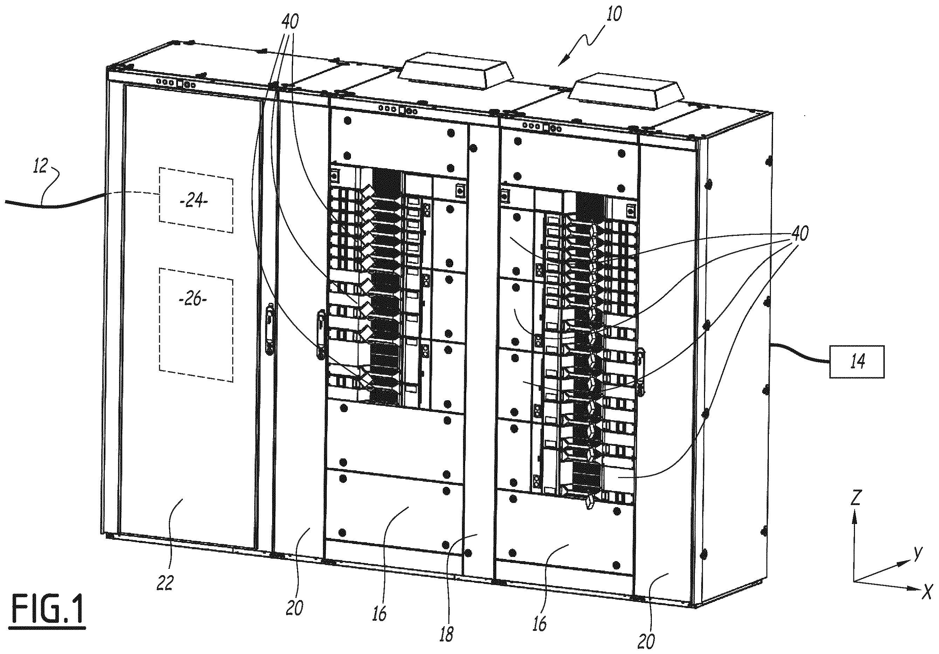

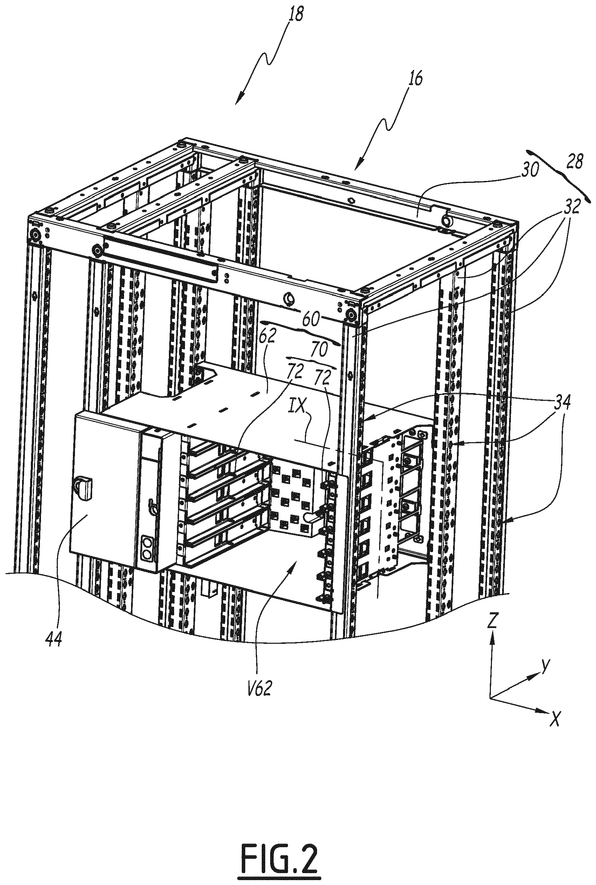

Une armoire électrique 10 est représentée aux figures 1 et 2. Cette armoire électrique est destinée à être intégrée à un réseau électrique partiellement représenté. Ce réseau électrique comprend d'une part, en amont de l'armoire électrique 10, des câbles d'alimentation 12 provenant par exemple d'un poste de transformation et d'autre part, en aval de l'armoire électrique, une ou des charges électriques 14.

L'armoire électrique 10 est une armoire de raccordement configurée pour raccorder les charges électriques 14 aux câbles d'alimentation 12.

Le câble d'alimentation 12 délivre à l'armoire électrique 10 une alimentation électrique principale, de préférence d'une tension de 400V triphasée avec neutre, de préférence à une fréquence 50Hz. En variante, le câble d'alimentation 12 délivre un courant triphasé sans neutre, ou un courant monophasé. En variante, l'alimentation est délivrée à une fréquence de 60Hz et à une tension différente, par exemple 1000V.

Les charges électriques 14 peuvent par exemple être des moteurs électriques, tels que des moteurs triphasés, des réseaux de distribution d'électricité, ou encore des charges électriques pilotables, tels que des batteries ou des panneaux photovoltaïques.

On définit un axe longitudinal X de l'armoire électrique 10 comme étant l'axe de la plus grande dimension de l'armoire électrique 10, en pratique sa longueur, un axe transversal Y comme étant l'axe de la plus petite dimension de l'armoire électrique 10 et perpendiculaire à l'axe X, en pratique sa largeur, et un axe vertical Z comme étant le troisième axe d'un repère orthogonal comprenant les axes X et Y.

L'orientation des axes X, Y et Z est liée fixement à l'orientation de l'armoire électrique 10. L'orientation de l'armoire électrique 10 décrite dans le présent exposé correspond à sa configuration montée. Il est donc entendu que l'orientation des axes X, Y et Z varie lorsque l'orientation de l'armoire électrique 10 varie. Par exemple, l'axe Z peut ne pas être vertical lorsque l'armoire 10 n'est pas en configuration montée, par exemple lorsqu'elle est transportée. Les qualificatifs « haut », « bas » et « vertical » utilisés dans la suite de l'exposé s'entendent relativement à l'axe Z.

Dans la configuration montée ici décrite, le plan formé par les axes X et Y est horizontal. Le qualificatif « horizontal » utilisé dans la suite de l'exposé s'applique à tout élément contenu dans un plan parallèle au plan formé par les axes X et Y, en configuration montée de l'armoire électrique 10. Les qualificatifs « gauche » et « droite » s'entendent relativement à l'axe X et les qualificatifs « avant » et « arrière » s'entendent relativement à l'axe Y, et relativement aux orientations représentées sur les figures.

Le positionnement relatif des pièces et leur orientation décrits ci-après sont donnés à titre d'exemple uniquement et ne sont pas limitatifs. Sauf en cas de mention contraire explicite, ils s'entendent en configuration montée et installée de l'armoire électrique 10. Ainsi, lorsqu'il est fait mention de l'orientation d'une pièce vis-à-vis des axes X, Y et/ou Z, elle s'entend en configuration montée de l'armoire. Lorsque l'armoire 10 est stockée, transportée, non-assemblée ou en cours d'assemblage, entre-autres exemples, l'orientation des pièces et leur positionnement relatif peuvent varier.

Comme visible à la figure 1, l'armoire électrique 10 comprend plusieurs colonnes 16, juxtaposées selon l'axe X.

En pratique, l'armoire électrique 10 comprend au moins une colonne de raccordement 16. Dans l'exemple, l'armoire électrique 10 comprend deux colonnes de raccordement 16. Chaque colonne de raccordement 16 permet le raccordement électrique d'une ou de plusieurs charges électriques 14 à l'armoire électrique 10 et permet de contrôler les charges électriques 14 qui y sont raccordées.

En outre, chaque colonne de raccordement 16 comprend des éléments fonctionnels 17, comme détaillés ci-après.

Avantageusement, l'armoire électrique 10 comprend également au moins une colonne de distribution électrique 18. Chaque colonne de distribution électrique 18 raccorde une ou deux colonnes de raccordement 16 au câble d'alimentation 12.

De préférence, chaque colonne de distribution électrique 18 comprend un jeu de barres d'alimentation, non-représenté, pour effectuer ce raccordement.

Avantageusement, l'armoire électrique 10 comprend également au moins une colonne de câblage 20. Chaque colonne de câblage 20 comprend des câbles électriques, non-représentés, qui relient une colonne de raccordement 16 à une ou plusieurs charges électriques 14. Ainsi, une colonne de câblage 20 est associée à chaque colonne de raccordement 16.

Avantageusement, l'armoire électrique 10 comprend également une colonne principale 22, qui comprend, par exemple, un disjoncteur 24 permettant de couper l'alimentation provenant du câble d'alimentation 12 et un ordinateur industriel 26 ou un module de connexion à un ordinateur industriel.

Comme visible à la figure 2, l'armoire électrique 10 comprend une ossature 28. L'ossature 28 forme une structure de l'armoire électrique 10 et supporte les éléments fonctionnels 17.

À la figure 2, seule une partie de l'ossature, correspondant à une colonne de raccordement et à une colonne de distribution électrique, est représentée.

L'ossature 28 comprend en pratique des traverses horizontales 30, disposées aux extrémités haute et basse de l'armoire électrique 10 et parallèles au plan formé par les axes X et Y, et des poteaux verticaux 32, qui s'étendent selon des axes parallèles à l'axe Z et qui relient les traverses horizontales 30. L'ossature 28 est de forme parallélépipédique.

Des trous de fixation 34 sont ménagés sur les poteaux verticaux 32.

Les éléments fonctionnels 17 des colonnes de raccordement 16 de l'armoire électrique 10 sont, en pratique, des éléments permettant d'assurer le bon fonctionnement de l'armoire.

De manière avantageuse, les éléments fonctionnels 17 sont regroupés en modules fonctionnels 40, dont sept sont représentés à la figure 1, répartis sur deux colonnes de raccordement 16.

De préférence, chaque module fonctionnel 40 comprend tout ou partie des éléments fonctionnels 17 suivants :
- un ou plusieurs tiroirs de contrôle-commande 42 ;
- une unité de protection 44 ;
- une ou plusieurs unités de raccordement 46 ;
- un tronçon de bus informatique 48 ; et
- une ou plusieurs unités d'entrées-sorties 50.

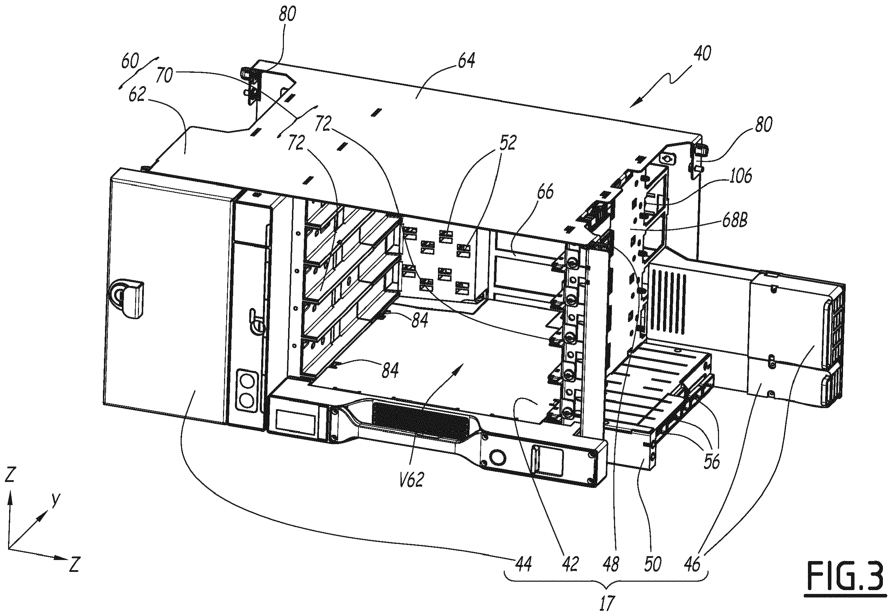

Un module fonctionnel 40 comprenant un tiroir de contrôle-commande 42, une unité de protection 44, deux unités de raccordement 46, un tronçon de bus informatique 48 et une unité d'entrées-sorties 50 est représenté à la figure 3.

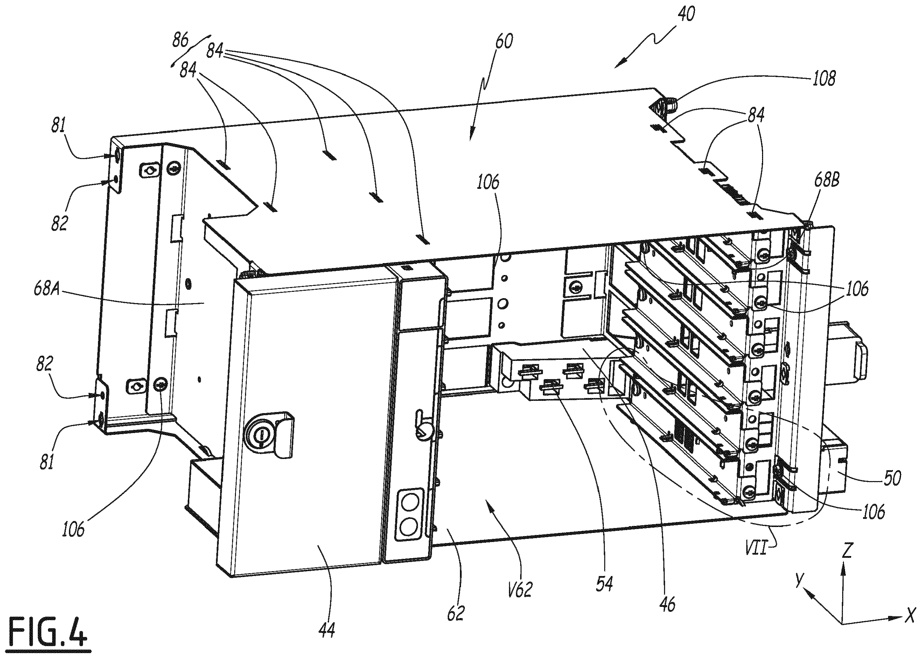

À la figure 4, l'unité de protection 44, une unité de raccordement 46 et une unité d'entrées-sorties sont représentées.

Aux figures 2, 5 et 6, seule l'unité de protection 44 est représentée.

Chaque tiroir de contrôle-commande 42 permet le raccordement électrique et éventuellement le pilotage et/ou la surveillance d'une charge électrique 14. Ainsi, le courant électrique provenant du câble d'alimentation 12 est redirigé vers les charges électriques 14 au travers des tiroirs de contrôle-commande 42.

En pratique, un module fonctionnel 40 comprend un ou plusieurs tiroirs, de préférence entre un et six tiroirs.

En outre, selon la nature de la charge électrique 14 contrôlée par un tiroir de contrôle-commande 42 et selon les fonctions de pilotage et/ou de surveillance effectuées par ce tiroir, la hauteur du tiroir, mesurée parallèlement à l'axe Z, peut varier, comme cela est visible à la figure 1.

De plus, chaque tiroir de contrôle-commande 42 est mobile en translation dans une colonne de raccordement 16, entre une position embrochée dans laquelle le tiroir est raccordé d'une part au câble d'alimentation 12 et d'autre part à la charge électrique 14 qu'il alimente, et une position débrochée, dans laquelle le tiroir n'est raccordé ni au câble d'alimentation ni à la charge électrique.

Le tiroir 42 est représenté en position embrochée sur la figure 3.

Chaque unité de protection 44 est configurée pour protéger électriquement un ou plusieurs tiroirs de contrôle-commande 42 ainsi que les charges électriques 14 qui sont raccordées à ces tiroirs, notamment en cas de défaillance d'une charge électrique 14, comme par exemple un court-circuit.

Les unités de protection 44 sont, par exemple, des disjoncteurs disposés en amont des tiroirs de contrôle-commande 42 et qui permettent d'interrompre le courant électrique alimentant les charges électriques 14 par l'intermédiaire des unités de contrôle-commande 42 en cas d'incident. En d'autres termes, les unités de protection 44 contrôlent l'alimentation en électricité des tiroirs de contrôle-commande 42 et sont disposées entre les tiroirs 42 et une colonne de distribution électrique 18.

Avantageusement, l'unité de protection 44 d'un module fonctionnel 40 protège tous les tiroirs de contrôle-commande 42 de ce module fonctionnel. En d'autres termes, l'unité de protection 44 d'un module fonctionnel 40 est commune à tous les tiroirs de contrôle-commande 42 de ce module fonctionnel.

En outre, chaque unité de protection 44 comprend des connecteurs fixes amont 52. Lorsqu'un tiroir de contrôle-commande 42 est en position embrochée, ce tiroir est embroché sur les connecteurs fixes amont 52, de sorte à être électriquement relié à l'unité de protection 44. Lorsqu'un tiroir est en position débrochée, il est distant des connecteurs fixes amont 52.

Chaque unité de raccordement 46 est associée à un tiroir de contrôle-commande 42. Ainsi, un module fonctionnel 40 comprend autant d'unités de raccordement 46 que de tiroirs 42.

Chaque unité de raccordement 46 est configurée pour qu'une charge électrique 14 y soit raccordée et pour alimenter cette charge électrique en énergie électrique, à partir d'un tiroir de contrôle-commande 42. Ainsi, une unité de raccordement 46 est disposée en intermédiaire, et raccordée, entre un tiroir 42 et une charge électrique 14.

En pratique, comme visible aux figures 3 et 4, une unité de raccordement 46 s'étend en partie en-dehors du module fonctionnel 40, vers la colonne de câblage 20 adjacente.

Ainsi, le câblage nécessaire au raccordement d'une charge électrique 14 sur une unité de raccordement 46 s'effectue dans la colonne de câblage 20, plutôt que dans la colonne de raccordement 16, ce qui est avantageux. En effet, l'espace disponible étant plus important dans la colonne de câblage 20, ce raccordement est ainsi facilité. En pratique, un grand nombre de câbles de raccordement peut être disposé dans une colonne de câblage 20, par exemple jusqu'à cent câbles.

En outre, chaque unité de raccordement 46 comprend des connecteurs fixes aval 54. Lorsqu'un tiroir de contrôle-commande 42 est en position embrochée, le tiroir est embroché sur les connecteurs fixes aval 54 de sorte à être électriquement relié à l'unité de raccordement 46. Lorsqu'un tiroir est en position débrochée, il est distant des connecteurs fixes aval 54.

L'embrochement du tiroir de contrôle-commande 42 sur des connecteurs fixes amont 52 et aval 54 est avantageux, car cela permet de facilement raccorder ou débrancher le tiroir, simplement en déplaçant le tiroir dans le module fonctionnel 40.

Ainsi, il n'est pas nécessaire d'effectuer des opérations de raccordement spécifiques pour basculer un tiroir de contrôle-commande 42 en position embrochée.

Le tronçon de bus informatique 48 d'un module fonctionnel 40 connecte chaque tiroir de contrôle-commande 42 à l'ordinateur industriel 26, de sorte à permettre l'échange de données, telles que des consignes de fonctionnement ou des mesures réalisées par des capteurs, entre les tiroirs et l'ordinateur industriel.

Dans l'exemple représenté, le tronçon de bus informatique 48 est une carte électronique qui s'étend verticalement et qui porte des circuits électroniques ainsi que des pistes d'alimentation électrique, non-représentés.

Chaque unité d'entrées-sorties 50 permet de connecter d'une part un tiroir de contrôle-commande 42 d'un module fonctionnel 40 au tronçon de bus informatique 48 de ce module fonctionnel, et d'autre part, grâce à des connecteurs d'entrées-sorties 56, l'armoire électrique 10 à des capteurs disposés à proximité de la charge électrique 14 et/ou à des fonctions auxiliaires de la charge électrique 14 et/ou à des organes de commande, par l'intermédiaire du tronçon de bus informatique 48.

Les capteurs disposés à proximité de la charge électrique 14 sont par exemple des capteurs de fonctionnement de la charge électrique 14, comme des capteurs de vitesse lorsque la charge électrique est un moteur, ou des capteurs de température. Les fonctions auxiliaires de la charge électrique 14 sont par exemple des actionneurs agissant sur la charge électrique, ou encore un circuit de chauffe, permettant de maintenir la charge électrique au-dessus d'une température minimale. Les organes de commande sont par exemple des dispositifs d'arrêt d'urgence de la charge électrique 14.

En outre, le raccordement des capteurs et/ou des fonctions auxiliaires de la charge électrique 14 aux connecteurs d'entrées-sorties 56 s'effectue dans la colonne de câblage 20 adjacente à l'unité d'entrées-sorties 50, car cette unité s'étend en-dehors du module fonctionnel 40, comme cela est visible aux figures 3 et 4.

Chaque unité d'entrées-sorties 50 est associée à un tiroir de contrôle-commande 42. Ainsi, un module fonctionnel 40 comprend autant d'unité d'entrées-sorties 50 que de tiroirs 42.

La connexion entre une unité d'entrées-sorties 50 et un tiroir de contrôle-commande 42 s'effectue à l'aide de contacts mobiles, non-représentés. Ces contacts mobiles sont configurés pour établir cette connexion dès que le tiroir est déplacé en position embrochée, de sorte qu'aucune opération de raccordement spécifique ne soit nécessaire pour établir cette connexion.

Le tronçon de bus informatique 48 est avantageux car il permet de centraliser toutes les connexions et tous les échanges de données entre l'ordinateur industriel 26, les tiroirs de contrôle-commande 42 et les charges électriques 14 dans une carte électronique, ce qui facilite la mise en oeuvre de ces connexions et réduit la quantité de câbles devant être mis en place dans l'armoire électrique 10.

En outre, chaque tiroir de contrôle-commande d'un module fonctionnel 40 communique également des informations avec l'unité de protection 44 du module fonctionnel, par l'intermédiaire d'un contact mobile non-visible.

Comme visible aux figures 2 à 4, chaque module fonctionnel 40 comprend un caisson de supportage 60, qui supporte tous les éléments fonctionnels 17 de ce module fonctionnel 40.

Le caisson de supportage 60 d'un module fonctionnel 40 comprend une armature 62 de forme parallélépipédique, qui définit un volume interne V62. L'armature 62 est montée dans l'ossature 28 de la colonne de raccordement 16, comme visible à la figure 2.

L'armature 62 comprend :
- deux plaques 64, horizontales en configuration montée du caisson dans l'ossature, parmi lesquelles on distingue une plaque haute et une plaque basse. En configuration montée du caisson dans l'ossature, les plaques 64 sont parallèles aux axes X et Y ;
- un fond 66, perpendiculaire aux plaques horizontales 64 et vertical en configuration montée du caisson dans l'ossature. En configuration montée du caisson dans l'ossature, le fond est parallèle aux axes X et Z ; et
- deux parois 68A et 68B, perpendiculaires aux plaques 64 et au fond 66 et verticales en configuration montée du caisson dans l'ossature, parmi lesquelles on distingue une paroi gauche 68A et une paroi droite 68B. En configuration montée du caisson dans l'ossature, les parois 68A et 68B sont parallèles aux axes Y et Z.

De préférence, les plaques 64, le fond 66 et les parois 68A et 68B sont réalisées en métal, par exemple en acier ayant subi un traitement de surface, comme un acier revêtu de zinc, dit « électrozingué », ou en acier galvanisé.

Le caisson de supportage 60 comprend en outre au moins une paire de rails 70 de guidage en translation d'un tiroir de contrôle-commande 42, de préférence six paires de rails de guidage 70.

En pratique, chaque paire de rails de guidage 70 comprend deux rails 72 qui sont configurés pour permettre l'insertion d'un tiroir de contrôle-commande 42 dans l'armoire électrique 10, de sorte que le tiroir est mobile en translation entre sa position débrochée et sa position embrochée, parallèlement à l'axe Y. Chaque paire de rails 70 est disposée de manière à ce qu'un tiroir de contrôle-commande 42 inséré dans cette paire de rails soit horizontal.

Le tiroir 42 comprend par exemple des roulettes, non-représentées, lui permettant de rouler dans les rails 72 d'une paire de rails 70.

De plus, chaque paroi verticale 68A et 68B supporte l'un des deux rails 72 de chaque paire de rails 70.

Les rails 72 s'étendent selon l'axe Y de profondeur de l'armoire électrique 10 et sont horizontaux. Ainsi, les tiroirs de contrôle-commande 42 sont également horizontaux lorsqu'ils sont insérés dans l'armoire électrique 10.

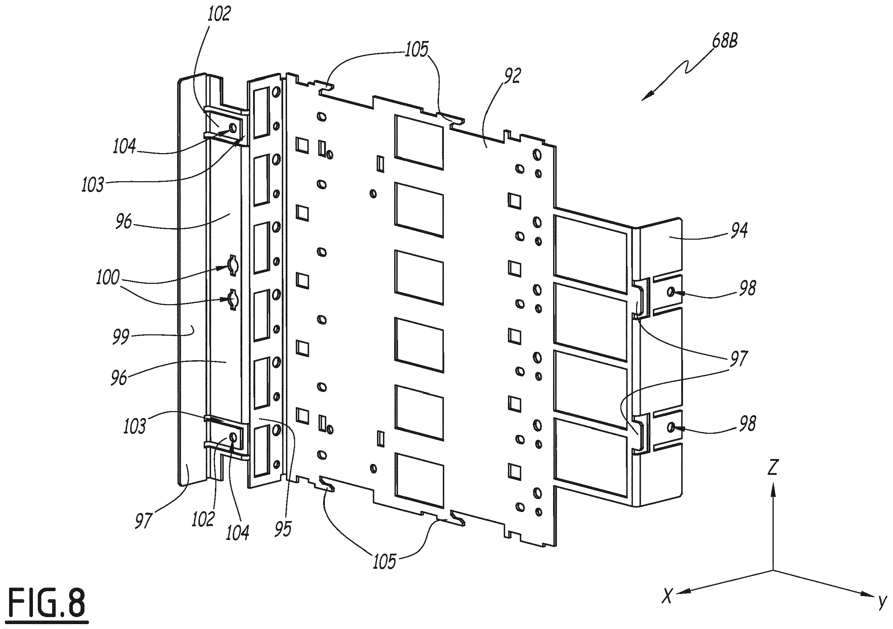

Un premier mode de réalisation du caisson 60 est représenté aux figures 2 à 9.

Dans ce premier mode de réalisation, l'unité de protection 44 est fixée à la paroi 68A de gauche, à l'intérieur du volume V62. Ainsi, les rails 72 situés sur la gauche du caisson 60 sont fixés sur l'unité de protection 44. Dans cette configuration, les rails 72 situés sur la gauche du caisson 60 sont tout de même supportés par la paroi verticale 68A, puisque l'unité de protection 44 est elle-même fixée à cette paroi verticale.

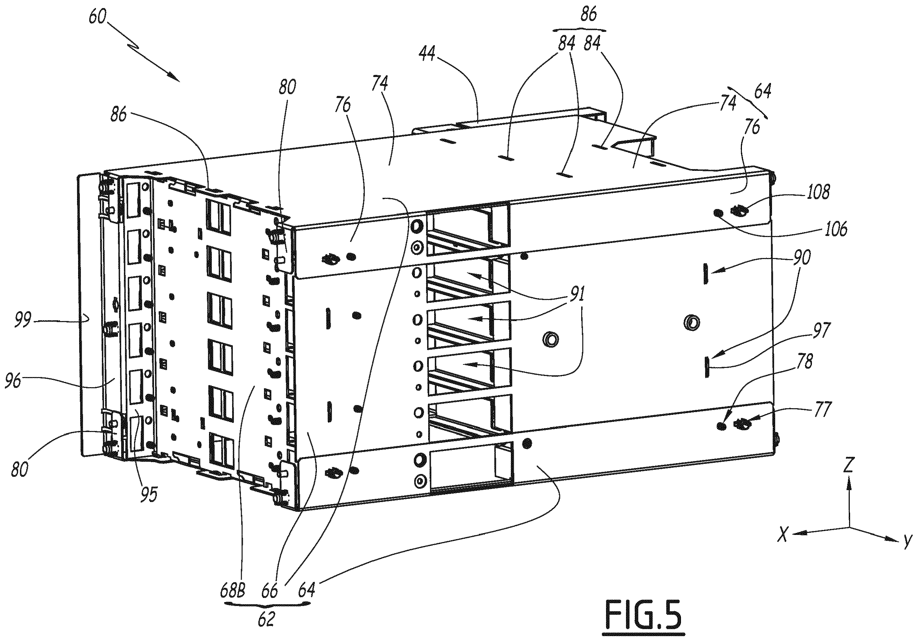

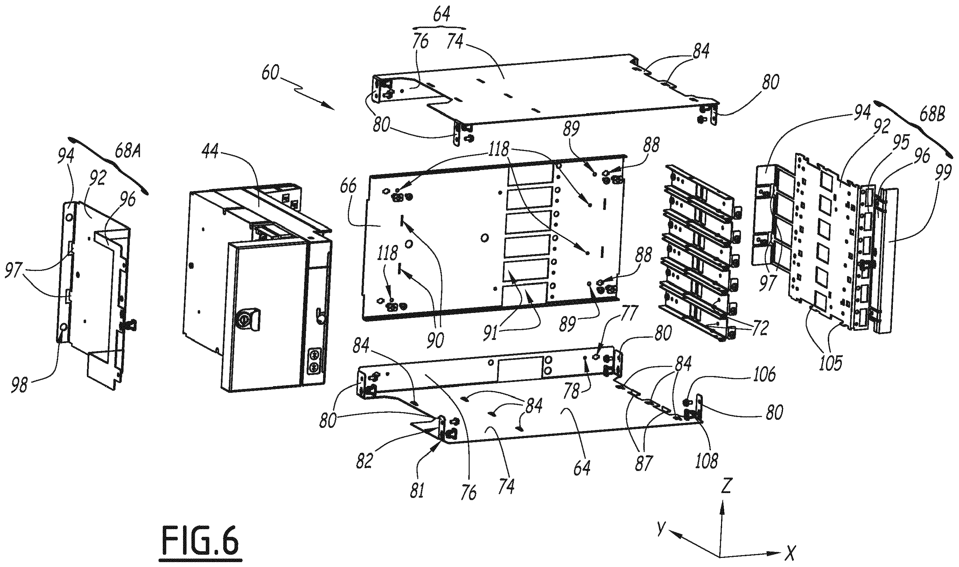

Comme mieux visible aux figures 5 et 6, chaque plaque 64 de l'armature 62 comprend un voile principal 74, horizontal, et une bordure 76, perpendiculaire au voile principal et parallèle au fond 66 de l'armature.

Dans chaque bordure 76 sont ménagés des trous de positionnement 77 et des trous de fixation 78, dont les axes sont parallèles à l'axe Y.

En outre, le voile principal 74 de chaque plaque 64 comprend plusieurs organes de fixation de l'armature 62 sur l'ossature 28 de l'armoire électrique 10, qui sont dans l'exemple des pattes de fixation 80.

Les pattes de fixation 80 d'une plaque horizontale 64 sont monobloc avec cette plaque. Elles sont perpendiculaires au voile principal 74 et à la bordure 76, de sorte à être parallèles aux parois verticales 68A et 68B en configuration montée du caisson 60, et s'étendent depuis le voile principal 74 d'une plaque horizontale en direction de l'autre plaque horizontale de l'armature 62.

Dans l'exemple représenté, chaque plaque horizontale 64 comprend quatre pattes de fixation 80, chaque patte de fixation étant configurée pour être fixée à un poteau vertical 32 de l'ossature 28.

De plus, chaque patte de fixation 80 comprend un trou de positionnement 81 et un trou de fixation 82, dont les axes sont parallèles à l'axe X.

Ainsi, chaque plaque horizontale 64 est, en configuration montée du caisson dans l'ossature, fixée à quatre poteaux verticaux 32.

En outre, les pattes de fixation 80 sont élastiquement déformables, de sorte à accommoder des variations de dimensions dans l'écartement des poteaux verticaux 32, comme détaillé ci-après.

Chaque plaque horizontale 64 comprend en outre des ergots 84, disposés sur le voile principal 74.

Les ergots 84 forment des protrusions, qui s'étendent depuis le voile principal 74 dans le volume V62 du caisson 62.

Dans l'exemple représenté, les ergots 84 sont monobloc avec le voile principal 74 et sont formés par découpe puis emboutissage localisé du voile principal.

Sur chaque voile principal, les ergots 84 sont répartis en deux groupes, qui forment chacun un guide de positionnement 86. En pratique, chaque guide de positionnement 86 comprend deux rangées adjacentes d'ergots 84, chaque rangée comprenant au moins deux ergots 84 alignés selon un axe parallèle à l'axe Y.

Chaque plaque horizontale 64 comprend également des doigts de positionnement 87, de préférence deux doigts 87. Les doigts de positionnement 87 d'une plaque horizontale 64 s'étendent perpendiculairement au voile principal 74 de cette plaque, de manière à être parallèles aux parois 68A et68B en configuration montée du caisson 60 et sont dirigés, en partant du voile d'une plaque horizontale 64, vers l'autre plaque horizontale de l'armature.

Le fond 66 de l'armature 62 du caisson 60 est fixé aux bordures 76 des deux plaques horizontales 64.

Pour permettre cette fixation, le fond 66 comprend des trous de positionnement 88 et des trous de fixation 89, respectivement alignés avec les trous de positionnement 77 et avec les trous de fixation 78 des bordures 76 des plaques horizontales.

Le fond 66 comprend en outre des encoches 90, dans l'exemple quatre encoches 90, permettant de positionner les parois verticales 68A et 68B.

Le fond 66 comprend en outre des trous de fixation 118, dans l'exemple quatre trous de fixation 118, permettant de fixer les parois verticales 68A et 68B.

Le fond 66 comprend en outre des ouvertures 91. Lorsqu'un tiroir de contrôle-commande 42 est monté dans le caisson de supportage 60, l'arrière du tiroir se situe en regard d'une ouverture 91, ce qui permet d'extraire de l'air du tiroir 42 au travers de l'ouverture 91, de sorte à assurer un refroidissement du tiroir.

En pratique, les connecteurs fixes amont 52 et les connecteurs fixes aval 54 d'un module fonctionnel 40 sont disposés de part et d'autre des ouvertures 91, selon l'axe transversal Y.

Les parois 68A et 68B de l'armature 62 du caisson 60 comprennent chacune un panneau principal 92, un rebord arrière 94 et un rebord avant 96.

Chaque paroi 68A et 68B comprend en outre des saillies 97, de préférence deux saillies 97. Chaque saillie 97 s'étend depuis le panneau principal 92 vers l'arrière du caisson 60, dans le prolongement du panneau principal.

Le rebord arrière 94 de chaque paroi 68A et 68B est perpendiculaire au panneau principal 92, c'est-à-dire que le rebord arrière est parallèle au fond 66 du caisson.

Le rebord avant 96 de chaque paroi 68A et 68B est parallèle au panneau principal 92, mais décalé, selon un axe parallèle à l'axe X, du panneau principal. Une bande 95, parallèle au rebord arrière 94, relie le panneau principal 92 et le rebord avant 96. Une lisière 99 prolonge le rebord avant 96, à l'opposé de la bande 95, cette lisière étant parallèle à la bande 95.

Sur le rebord arrière 94 de chaque paroi 68A et 68B est ménagé au moins un trou de fixation 98, de préférence deux trous de fixation 98.

Sur le rebord avant 96 de chaque paroi 68A et 68B est ménagé au moins un trou de positionnement 100, de préférence deux trous de positionnement 100.

En outre, le rebord avant 96 de chaque paroi 68A et 68B comprend également au moins une patte de reprise de charge 102, de préférence deux pattes de reprise de charge 102. Les pattes de reprise de charge 102 constituent également des organes de fixation de l'armature 62 sur l'ossature 28 de l'armoire électrique 10. Chaque patte 102 de reprise de charge est délimitée par une encoche 103 en U découpée dans le rebord 96. Chaque patte 102 présente une souplesse perpendiculairement au plan du rebord 96.

Sur chaque patte de reprise de charge 102 est ménagé un trou de fixation 104.

En variante non-représentée de l'invention, les parois 68A et 68B ne comprennent pas de rebord avant 96 et le ou les trous de positionnement 100 ainsi que les pattes de reprise de charge 102 sont ménagés sur le panneau principal 92.

En variante non-représentée de l'invention, les parois 68A et 68B ne comprennent pas de patte de reprise de charge 102.

La paroi 68B comprend en outre des doigts de positionnement 105, de préférence quatre doigts de positionnement 105, respectivement ménagés sur les arêtes supérieure et inférieure du voile principal 74.

Chaque paroi 68A et 68B est fixée d'une part au fond 66 du caisson 60 et d'autre part à l'ossature 28 de l'armoire électrique 10.

En outre, chaque paroi 68A et 68B est maintenue par les plaques horizontales 64, en étant située dans un guide de positionnement 86 de chaque plaque horizontale.

Ainsi, chaque guide de positionnement 86 est configuré pour positionner une paroi 68A ou 68B par rapport à la plaque horizontale 64 comprenant ce guide de positionnement.

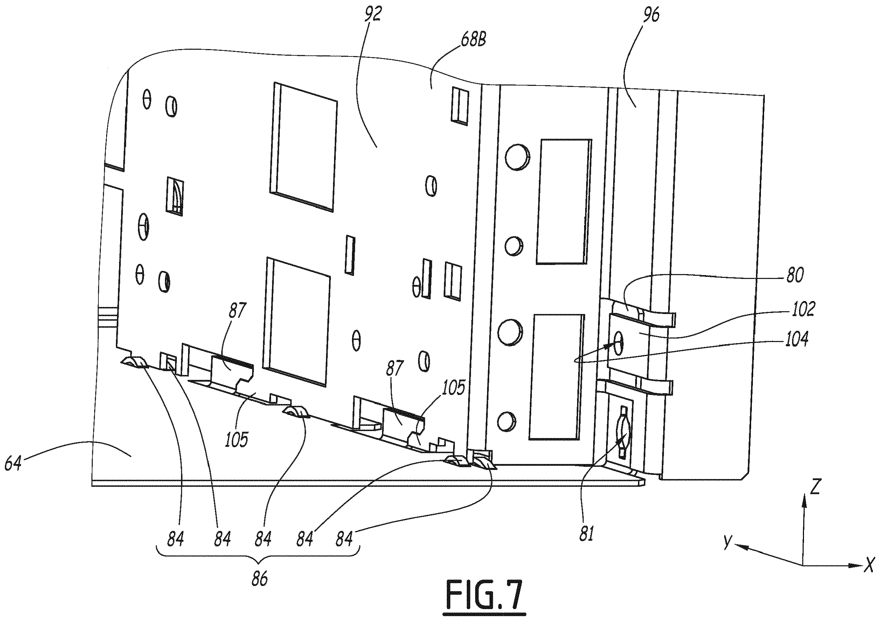

Comme cela est mieux visible à la figure 7, sur laquelle les rails 72 sont omis, la paroi 68B représentée sur cette figure est entourée de part et d'autre par les ergots 84, de sorte que tout mouvement de translation de cette paroi selon l'axe X est empêché.

Comme cela ressort des figures 3 et 4, la paroi 68A, à laquelle l'unité de protection 44 est fixée, est maintenue différemment par les guides de positionnement 86. En effet, pour chaque plaque 64, une première rangée d'ergots 84 est disposée à gauche de la paroi 68A et une deuxième rangée d'ergots 84 est disposée à droite de l'unité de protection 44, de sorte à entourer à la fois la paroi 68A et l'unité de protection 44.

En d'autres termes, les deux rangées d'ergots 84 maintenant la paroi verticale 68A sont écartées, selon l'axe X, d'une distance sensiblement égale à la somme de l'épaisseur de la paroi 68A et de l'épaisseur de l'unité de protection 44 et les deux rangées d'ergots 84 maintenant la paroi verticale 68B sont écartées, selon l'axe X, d'une distance sensiblement égale à l'épaisseur de la paroi 68B.

En variante non-représentée de l'invention, l'unité de protection 44 comprend deux gorges, disposées sur une face supérieure et sur une face inférieure de l'unité de protection et qui s'étendent selon un axe parallèle à l'axe Y, configurées pour recevoir chacune une rangée d'ergots 84 d'une plaque horizontale 64. Dans cette variante, la paroi 68A et l'unité de protection 44 sont guidées par les guides de positionnement 86 mais les deux rangées d'ergots 84 formant ces guides de positionnement sont écartées, selon l'axe X, d'une distance inférieure à la somme de l'épaisseur de la paroi 68A et de l'épaisseur de l'unité de protection 44.

La fixation du fond 66 sur les plaques horizontales 64 et des parois 68A et 68B sur le fond 66 s'effectue à l'aide de vis 106 et de pions de centrage 108.

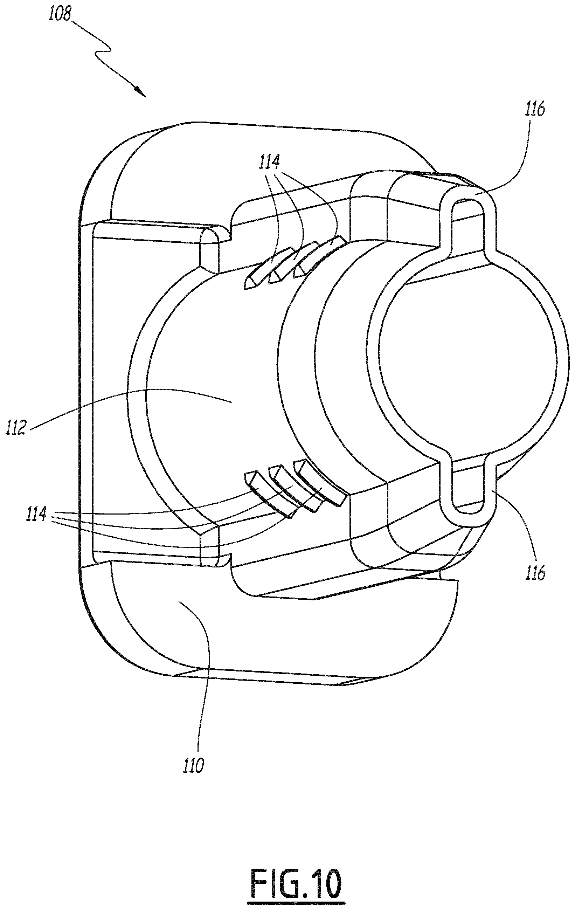

Un pion de centrage 108 est illustré seul à la figure 10.

Le pion de centrage 108 comprend une tête 110 et un corps 112, sur lequel plusieurs groupes de crans 114 sont ménagés. En pratique, chaque pion de centrage 108 comprend au moins deux groupes de crans 114. Dans l'exemple représenté, chaque pion comprend quatre groupes de trois crans. À la figure 10, seuls deux groupes de crans 114 sont visibles. Au sein d'un groupe, les différents crans 114 sont positionnées à des distances différentes de la tête 110 du pion de centrage 108. Le corps 112 de chaque pion de centrage 108 comprend également deux nervures 116 qui confère à ce corps une section non circulaire, adaptée à la forme des trous de positionnement ainsi qu'à la forme des trous de fixation 34 des poteaux verticaux 32.

De préférence, les pions de centrage 108 sont en matériau composite, de préférence encore en polyamide renforcé en fibres.

Le caisson 60 est assemblé directement dans l'armoire électrique 10, sur l'ossature 28.

Pour assembler le caisson 60 dans l'armoire électrique, les plaques horizontales 64 sont tout d'abord positionnées par rapport aux poteaux verticaux 32 de l'ossature 28 puis fixées aux poteaux verticaux, au cours d'une première étape d'assemblage. Pour cela, les trous de positionnement 81 des pattes de fixation 80 des plaques horizontales 64 sont alignés avec les trous de fixation 34 des poteaux verticaux, puis des pions de centrage 108 sont disposés dans les trous de positionnement 81, de sorte à s'étendre dans les trous de fixation 34 des poteaux verticaux 32 et à aligner, ou centrer, les plaques horizontales 64 par rapport aux poteaux verticaux. Lorsqu'un pion de centrage 108 est en place sur un poteau vertical 32, deux crans 114 du pion sont en contact avec le poteau, de sorte à maintenir les plaques horizontales 64 par rapport à ce poteau.

En pratique, les pions de centrage 108 permettent de positionner verticalement les plaques horizontales 64 par rapport à l'ossature 28, sans contraindre le positionnement horizontal des plaques. En effet, parmi les multiples paires de crans 114 d'un pion de centrage, seule une paire de crans fixe le pion de centrage sur un poteau vertical, en fonction de l'écartement entre la tête 110 du pion de positionnement et le poteau 32. En outre, le positionnement des plaques horizontales 64 définit le positionnement du caisson 60, car les autres éléments de l'armature 62 sont positionnés par rapport aux plaques horizontales. Les pions de centrage 108 permettent donc de pré-positionner le caisson 60.

Ainsi, le pré-positionnement du caisson de supportage 60 sur l'ossature 28 par les pions de centrage 108 est assuré indépendamment de la distance séparant le caisson d'un poteau vertical 32 au niveau de ce pion, tant que cette distance est inférieure à la distance mesurée entre la tête 110 du pion et la paire de crans 114 la plus éloignée de la tête 110.

En d'autres termes, les pions de centrage 108 permettent de s'adapter à un jeu entre le caisson de supportage 60 et les poteaux verticaux 32 de l'ossature 28.

Ainsi, les pions de centrage 108 permettent, d'une part, de faciliter l'assemblage du caisson de supportage 60 et, d'autre part, de faciliter le montage du caisson de supportage 60 dans l'ossature 28.

Ensuite, le fond 66 est assemblé aux plaques horizontales 64 au cours d'une deuxième étape d'assemblage. Pour cela, le fond 66 est positionné par rapport aux plaques horizontales 64, grâce à plusieurs pions de centrage 108, dans l'exemple grâce à quatre pions de centrage.

En pratique, chaque pion de centrage 108 est pré-monté dans un trou de positionnement 88 du fond 66, de manière à ce que la tête 110 du pion soit en contact avec le fond 66 et que le corps 112 du pion s'étende au travers du trou de positionnement 88.

Ensuite, le fond 66 est plaqué sur les bordures 76 des plaques horizontales 64, de sorte que le corps 112 de chaque pion de centrage 108 s'étende au travers d'un trou de positionnement 77 d'une bordure 76. Les crans 114 retiennent alors les pions dans les trous 77 et 88, donc le fond 66 en position par rapport aux bordures 76.

Ensuite, des vis 106 sont insérées dans les trous de fixation 89 du fond 66 et dans les trous de fixation 78 des bordures 76, de manière à fixer le fond 66 sur les bordures 76.

Dans une troisième étape d'assemblage, les parois verticales 68A et 68B sont positionnées. Pour cela, chaque paroi verticale 68A et 68B est glissée, dans un mouvement de translation selon un axe parallèle à l'axe Y, entre les plaques horizontales 64, jusqu'à ce que son rebord arrière 94 entre en contact avec le fond 66 et jusqu'à ce que les saillies 97 du panneau principal 92 pénètrent dans les encoches 90 du fond 66. Au cours de ce mouvement, chaque paroi verticale 68A et 68B est guidée par deux guides de positionnement 86, à savoir un guide de positionnement ménagé sur chaque plaque horizontale 64. En outre, les doigts de positionnement 87 des plaques horizontales 64 et les doigts de positionnement 105 des parois verticales sont de forme complémentaires et en contact lorsque les parois verticales sont positionnées par rapport aux plaques 64 et au fond 66, de sorte à aider au bon positionnement des parois verticales.

En pratique, l'unité de protection 44 est montée sur la paroi verticale 68A préalablement à la troisième étape. Ainsi, c'est l'assemblage de la paroi verticale 68A et de l'unité de protection 44 qui est guidé entre les guides de positionnement 86 situés sur la gauche des figures 3, 4 et 6.

Après mise en contact du rebord arrière 94 d'une paroi verticale 68A ou 68B avec le fond 66 et insertion des saillies 97 dans les encoches 90, la paroi verticale et le fond sont fixés à l'aide de vis 106, insérées au travers des trous de fixation 98 du rebord arrière 94 et des trous de fixation 118 du fond 66.

En configuration assemblée de l'armature 62, les trous de fixation 104 des pattes de reprise de charge 102 des parois verticales 68A et 68B sont alignés avec les trous de fixation 82 des pattes de fixation 80 des plaques horizontales 64.

Des pions de centrage 108 sont ensuite disposés dans les trous de positionnement 100, de sorte à s'étendre dans les trous de fixation 34 des poteaux verticaux 32 et à participer à l'alignement du caisson 60 par rapport aux poteaux verticaux.

À l'issu de la troisième étape de l'assemblage, l'armature 62 est assemblée et le caisson 60 est positionné par rapport à l'ossature 28.

Lorsque l'assemblage de l'armature 62 est terminée, le caisson 60 est rigide, c'est-à-dire qu'il ne peut pas être déformé lorsque des efforts normaux d'utilisation lui sont appliqués. En effet, tout effort exercé sur un premier élément parmi l'ensemble constitué des deux plaques 64, du fond 66 et des deux parois 68A et 68B est transmis aux autres éléments de cet ensemble d'une manière à empêcher la déformation du premier élément.

Cette rigidité provient notamment du fait que l'assemblage de l'armature 62 empêche tout mouvement relatif entre les plaques 64, le fond 66 et les parois 68A et 68B.

Par exemple la présence du fond 66 empêche la structure formée des plaques horizontales 64 et des parois verticales 68 de se déformer en parallélogramme non-rectangle, c'est-à-dire de sorte que les parois verticales 68 ne soient plus perpendiculaires aux plaques horizontales 64.

Il est avantageux que le caisson 60 soit rigide, car cette rigidité garantit un positionnement fiable et précis des éléments fonctionnels 17, ainsi que des rails 72. Ce positionnement fiable et précis est utile, par exemple pour permettre aux tiroirs de contrôle-commande de rouler normalement dans les rails 72 et pour permettre l'embrochement des tiroirs sur les connecteurs fixes amont 52 et aval 54.

Cette précision est d'autant plus avantageuse que l'embrochement d'un tiroir de contrôle-commande sur des connecteurs fixes 52 et 54 est complexe lorsque les connecteurs amont 52 sont distants des connecteurs aval 54, comme dans l'exemple représenté où les connecteurs amont et aval sont de part et d'autre des ouvertures 91 du fond 66.

La rigidité du caisson 60 est d'autant plus avantageuse que l'ossature 28 de l'armoire électrique 10 peut présenter des défauts, de sorte que les poteaux 32 ne soient pas parfaitement verticaux. Cette rigidité permet de compenser ces défauts.

Par exemple, il est courant que les poteaux d'une ossature d'armoire électrique se déforment vers l'intérieur d'une colonne de raccordement 16, ce qui conduit à exercer des efforts sur le caisson 60 lorsqu'il est installé sur l'ossature, car la largeur entre deux poteaux verticaux peut alors être inférieure à la largeur du caisson 60. Grâce à la rigidité du caisson 60, dans une telle situation, les poteaux verticaux de l'ossature sont redressés de manière à être sensiblement verticaux et le caisson n'est pas déformé.

De plus, la fixation des plaques horizontales 64, du fond 66 et des parois verticales 68A et 68B s'effectue uniquement à l'aide de vis 106 et ne nécessite pas le recours à des opérations de fixation complexes, telles que par exemple de la soudure. L'armature 62 du caisson 60 est donc simple à assembler.

Ensuite, dans une quatrième étape de l'assemblage, l'avant du caisson 60 est fixé sur les poteaux verticaux grâce à des vis 106, qui sont montées au travers des trous de fixation 104 des pattes de reprise de charge 102 des parois verticales 68A et 68B, au travers des trous de fixation 82 des pattes de fixation 80 des plaques horizontales 64 et au travers des trous de fixation 34 des poteaux verticaux 32.

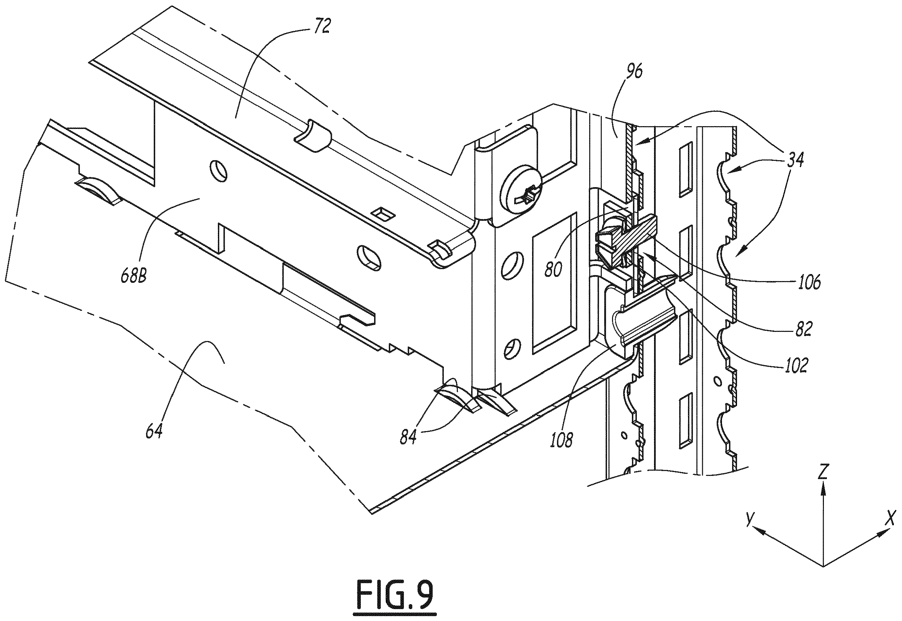

Dans le même temps, pendant la quatrième étape de l'assemblage, l'arrière du caisson 60 est fixé sur les poteaux verticaux grâce à des vis 106, qui sont montées au travers des trous de fixation 82 des pattes de fixation 80 des plaques horizontales 64 et au travers des trous de fixation 34 des poteaux verticaux 32. Cette étape de fixation est mieux visible à la figure 9.Ainsi, le caisson 60 est fixé à l'ossature 28 à l'aide de vis 106, par l'intermédiaire des pattes de fixation 80 et des pattes de reprise de charge 102.

Dans l'exemple représenté, des vis 106 identiques sont utilisées pour assembler l'armature 62, pour fixer les rails 72 aux parois verticales 68A et 68B et pour fixer le caisson 60 aux poteaux verticaux 32.

En variante non-représentée de l'invention, plusieurs types de vis différents sont utilisés pour assembler l'armature, pour fixer les rails aux parois verticales et pour fixer le caisson aux poteaux verticaux.

Cette méthode de fixation est particulièrement avantageuse, car les pattes de fixation 80 et les pattes de reprise de charge 102 sont élastiquement déformables, ce qui permet de compenser une éventuelle déformation de l'ossature 28.

En effet, lorsque par exemple les poteaux 32 de l'ossature 28 sont déformés vers l'extérieur de la colonne de raccordement 16, la largeur entre deux poteaux verticaux augmente de sorte à être supérieure à la largeur du caisson 60. Dans un tel exemple, les pattes de fixation 80 et les pattes de reprise de charge 102 vont se déformer lors du serrage des vis 106, jusqu'à être plaquées contre les poteaux 32 de l'ossature, sans que cette déformation n'affecte les autres éléments de l'armature 62 du caisson 60, qui est rigide.

En d'autres termes, lorsque le caisson de supportage 60 est fixé à une ossature 28 déformée, l'armature 62 du caisson n'est pas déformée et les pattes de fixation 80 et 102 sont déformées de manière à compenser les déformations de l'ossature 28. Ainsi, le caisson 60 est suspendu à l'ossature 28 par les pattes de fixation 80 et 102.

En résumé, grâce aux pattes de fixation 80 et aux pattes de reprise de charge 102 d'une part, et grâce à la rigidité du caisson 60 d'autre part, le caisson 60 peut être installé dans une ossature 28 dont les poteaux 32 sont déformés vers l'intérieur ou vers l'extérieur, sans que le caisson 60 ne soit déformé.

Grâce au caisson de supportage 60, le montage d'un module fonctionnel 40 sur l'ossature 28 s'effectue donc en s'adaptant aux éventuels défauts de l'ossature 28.

En outre, le poids d'un module fonctionnel 40 est transmis à l'ossature 28 de l'armoire électrique 10, sur l'avant du caisson, par l'intermédiaire des pattes de fixation 80, dans l'exemple quatre pattes, des pattes de reprise de charge 102, dans l'exemple quatre pattes, et des pions de centrage 108, dans l'exemple deux pions, disposés dans les trous de positionnement 100 du rebord avant 96 des parois verticales 68A et 68B et sur l'arrière du caisson par l'intermédiaire des pattes de fixation 80, dans l'exemple quatre pattes.

Dans une cinquième étape d'assemblage, les rails 72 sont fixés aux parois verticales 68A et 68B à l'aide de vis 106. De préférence, chaque rail 72 est fixé à une paroi verticale à l'aide de deux vis 106.

En variante, la cinquième étape d'assemblage est réalisée entre la troisième et la quatrième étape d'assemblage, c'est-à-dire avant la fixation du caisson sur les poteaux verticaux.

En variante, les rails 72 sont fixés au parois verticales 68A et 68B avant la troisième étape d'assemblage, c'est-à-dire avant le montage des parois verticales dans le caisson.

Les première à cinquième étapes mentionnées ci-dessus constituent ensemble une première étape, autrement une phase ou une opération, du procédé d'assemblage de l'invention.

Après installation du caisson de supportage 60 sur l'ossature 28 de l'armoire électrique 10, le caisson 60 est équipé, au cours d'une deuxième phase ou opération du procédé d'assemblage, avec les éléments fonctionnels 17, tels que les tiroirs de contrôle-commande 42, de manière à former un module fonctionnel 40.

En pratique, les tiroirs de contrôle-commande 42, les unités de raccordement 46 et les unités d'entrées-sorties 50 sont installés dans le caisson 60 après fixation du caisson sur l'ossature 28.

En pratique, le tronçon de bus informatique 48 est installé dans le caisson 60 indifféremment avant ou après fixation du caisson sur l'ossature de l'armoire électrique.

En résumé, l'assemblage de l'armoire électrique 10 comprend au moins deux phases distinctes, consistant à :
- assembler au moins un caisson de supportage 60 sur l'ossature 28 d'une ou de plusieurs colonnes de raccordement 16, entre les poteaux verticaux 32 ; et
- équiper chaque caisson 60 d'éléments fonctionnels 17 de sorte à former un module fonctionnel 40.

On remarque sur la figure 1 que, sur la colonne de raccordement 16 de gauche de l'armoire électrique de raccordement 10, les modules fonctionnels 40 ont une orientation inversée par rapport aux modules fonctionnels 40 de la colonne de raccordement 16 de droite et par rapport au caisson de supportage 60 représenté sur les figures 2 à 9.

En effet, le caisson de supportage 60 n'a pas d'orientation privilégiée, de sorte qu'il puisse être retourné de haut en bas avant d'être installé dans une colonne de raccordement 16. Lorsque le caisson de supportage 60 est retourné, les plaques 64 restent horizontales, la paroi verticale 68A est disposée sur la droite du caisson 60 et la plaque verticale 68B est disposée sur la gauche du caisson. Ce retournement n'affecte ni l'installation du caisson de supportage 60 dans une colonne de raccordement 16, ni le fonctionnement du module fonctionnel 40 comprenant ce caisson.

En outre, les éléments fonctionnels 17 n'ont pas d'orientation privilégiée et sont configurés pour pouvoir être également retournés.

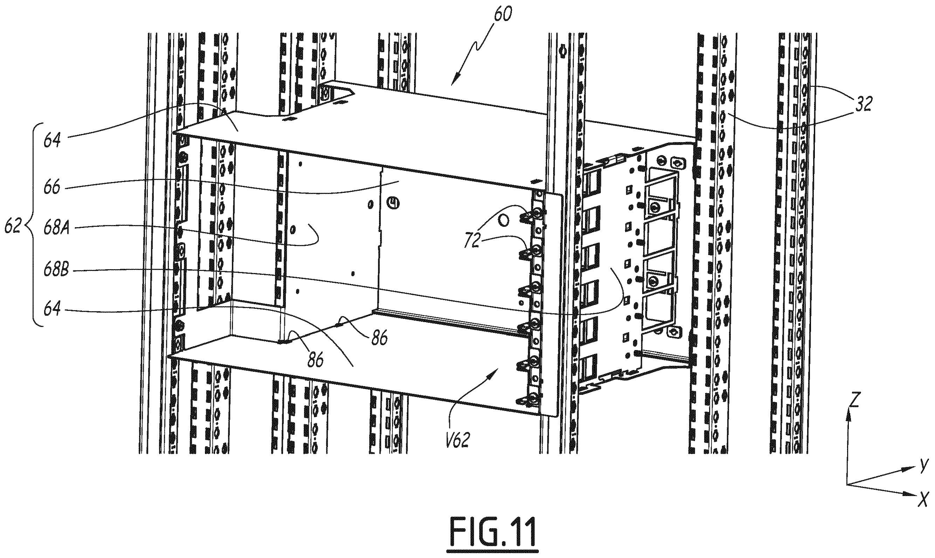

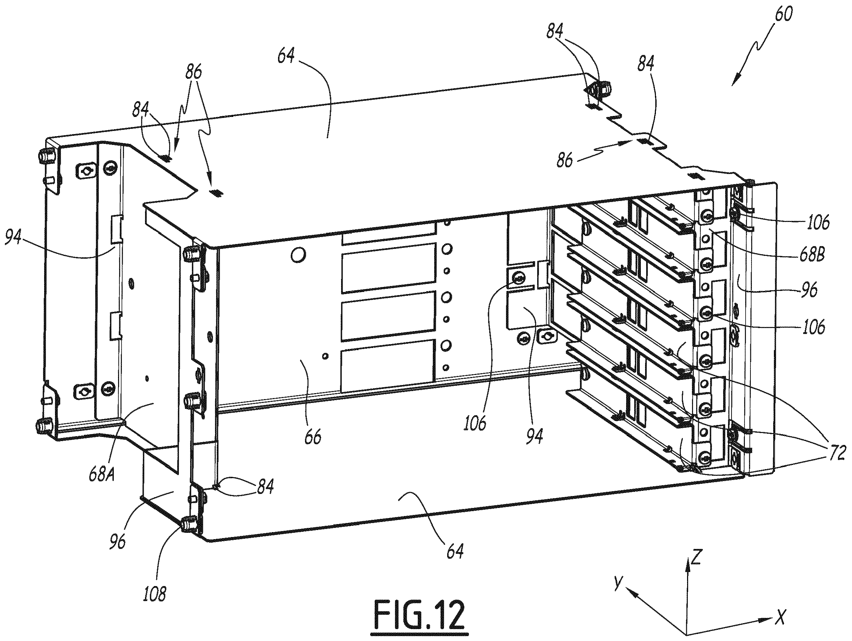

On décrit à présent, en référence aux figures 11 et 12, un deuxième mode de réalisation du caisson de supportage 60.

Dans ce deuxième mode de réalisation, les éléments analogues à ceux du premier mode de réalisation portent les mêmes références et fonctionnent de la même façon. Dans ce qui suit, on décrit principalement les différences entre les premier et deuxième modes de réalisation.

Dans le deuxième mode de réalisation, l'unité de protection 44, non-représentée sur les figures 11 et 12, est installée dans le caisson 60 après l'assemblage de l'armature 62.

Sur ces figures, les rails 72 supportés par la paroi verticale 68A ne sont pas représentés, pour plus de lisibilité.

En outre, dans ce deuxième mode de réalisation, la paroi 68A est maintenue seule entre les guides de positionnement 86, sans que l'unité de protection 44 ne participe à ce maintien.

Ainsi, au cours de l'assemblage du caisson 60, la paroi verticale 68A est glissée entre les plaques horizontales 64 en étant guidée par un guide de positionnement 86 de chaque plaque horizontale 64.

Pour cela, les ergots 84 entourant la paroi 68A forment deux rangées qui sont autant écartées l'une de l'autre, selon l'axe X, que les rangées d'ergots du guide de positionnement maintenant la paroi 68B, c'est-à-dire écartées d'une distance sensiblement égale à l'épaisseur de la paroi verticale 68A.

En variante non-représentée, les pattes de fixation 80 de l'arrière du caisson 60 ne sont pas monobloc avec les plaques horizontales 64 mais sont monobloc avec le fond 66 de l'armature 62.

## Revendications

1. Caisson de supportage (60) d'éléments fonctionnels (17) au sein de l'ossature (28) d'une armoire électrique de raccordement (10), ce caisson comprenant :
- au moins une paire (70) de rails de guidage (72) en translation d'un tiroir de contrôle-commande (42) constituant un élément fonctionnel (17) ;
- une armature (62) parallélépipédique comprenant :
∘ deux plaques (64) horizontales en configuration montée du caisson (60) dans l'ossature (28) ;
∘ un fond (66) perpendiculaire aux plaques (64) horizontales et vertical en configuration montée du caisson dans l'ossature ; et
∘ deux parois (68A, 68B) verticales en configuration montée du caisson dans l'ossature et qui supportent chacune un rail (72) de chaque paire de rails (70),
- des organes de fixation (80, 102) de l'armature (62) sur l'ossature (28),
**caractérisé en ce que**
- les organes de fixation de l'armature (62) sur l'ossature (28) de l'armoire électrique (10) comprennent des pattes de fixation (80) élastiquement déformables et monobloc avec les plaques horizontales (64),
- les organes de fixation de l'armature (62) sur l'ossature (28) de l'armoire électrique (10) comprennent des pattes de reprise de charge (102) élastiquement déformables, monobloc avec les parois verticales (68A, 68B),
- le caisson de supportage (60) comprend en outre au moins un pion de centrage (108), configuré pour centrer verticalement le caisson (60) par rapport à un poteau (32) de l'ossature (28) de l'armoire (10), chaque pion de centrage (108) étant disposé dans un trou de positionnement (81) d'une patte de fixation (80).

2. Caisson de supportage (60) selon la revendication 1, dans lequel chaque plaque (64) de l'armature (62) comprend un voile principal (74), horizontal en configuration montée du caisson (60) dans l'ossature (28) de l'armoire électrique (10), et une bordure (76), perpendiculaire au voile principal (74) et parallèle au fond (66) de l'armature, et dans lequel le fond de l'armature est fixé aux bordures des plaques.

3. Caisson de supportage (60) selon l'une quelconque des revendications précédentes, dans lequel chaque plaque horizontale (64) de l'armature (62) comprend des ergots (84) formant deux guides de positionnement (86), chaque guide de positionnement étant configuré pour positionner une paroi verticale (68A, 68B) de l'armature par rapport à la plaque horizontale comprenant ce guide de positionnement.

4. Caisson de supportage (60) selon l'une quelconque des revendications précédentes, dans lequel le fond (66) de l'armature (62) comprend au moins deux encoches (90), chaque encoche étant configurée pour positionner une paroi verticale (68A, 68B) de l'armature par rapport au fond.

5. Armoire électrique de raccordement (10) comprenant :
- une ossature (28), l'ossature étant de forme globalement parallélépipédique et comprenant des poteaux verticaux (32) ;
- au moins un caisson de supportage (60) selon l'une quelconque des revendications 1 à 4 ; et
- au moins un élément fonctionnel (17), dont au moins un tiroir de contrôle-commande (42), chaque élément fonctionnel (17) étant monté dans un caisson de supportage (60) et chaque tiroir de contrôle-commande étant mobile en translation dans une paire (70) de rails de guidage (72) d'un caisson.

6. Armoire électrique de raccordement (10) selon la revendication 5, dans laquelle les éléments fonctionnels (17) montés dans un caisson de supportage (60) comprennent au moins :
- au moins un tiroir de contrôle-commande (42),
- une unité de protection (44), l'unité de protection étant commune à tous les tiroirs de contrôle-commande (42) montés dans le caisson (60), alimentant en énergie électrique tous les tiroirs de contrôle-commande et protégeant électriquement tous les tiroirs de contrôle-commande, l'unité de protection étant fixée à une paroi verticale (68A) de l'armature (62) du caisson (60) et supportant le rail (72) de chaque paire de rails (70) associé à cette paroi verticale (68A),
- un tronçon de bus informatique (48) configuré pour connecter tous les tiroirs de contrôle-commande du caisson à un ordinateur industriel (26), et
- plusieurs modules de raccordement (46), notamment autant de modules de raccordement que de tiroirs de contrôle-commande, chaque module de raccordement (46) étant configuré pour raccorder électriquement un tiroir de contrôle-commande à une charge électrique (14).

7. Procédé d'assemblage d'une armoire électrique de raccordement (10), comprenant au moins des phases consistant à :
- assembler un caisson de supportage (60) selon l'une des revendications 1 à 4 sur l'ossature (28) d'une colonne (16), entre des poteaux verticaux (32) ; et
- équiper le caisson, en place dans la colonne, avec des éléments fonctionnels (17).

## Patentansprüche

1. Trägerkasten (60) für Funktionselemente (17) innerhalb des Gerüsts (28) eines elektrischen Anschlussschranks (10), wobei dieser Kasten umfasst:
- mindestens ein Paar (70) Schienen (72) zur translatorischen Führung eines Kontroll-Steuerungs-Einschubs (42), der ein Funktionselement (17) darstellt;
- einen parallelepipedischen Rahmen (62), umfassend:
o zwei horizontale Platten (64) in der in das Gerüst (28) eingebauten Konfiguration des Kastens (60);
o einen Boden (66), der senkrecht zu den horizontalen Platten (64) vertikal in der in das Gerüst eingebauten Konfiguration des Kastens ist; und
o zwei vertikale Wände (68A, 68B) in der in das Gerüst eingebauten Konfiguration des Kastens und die jeweils eine Schiene (72) jedes Schienenpaars (70) tragen,
- Organe (80, 102) zur Befestigung des Rahmens (62) am Gerüst (28),
**dadurch gekennzeichnet, dass**
- die Organe zur Befestigung des Rahmens (62) am Gerüst (28) des elektrischen Schranks (10) elastisch verformbare, mit den horizontalen Platten (64) einteilige Befestigungslaschen (80) umfassen,
- die Organe zur Befestigung des Rahmens (62) am Gerüst (28) des elektrischen Schranks (10) elastisch verformbare, mit den vertikalen Wänden (68A, 68B) einteilige Lastübernahmelaschen (102) umfassen,
- der Trägerkasten (60) ferner mindestens einen Zentrierstift (108) umfasst, der dazu ausgelegt ist, den Kasten (60) in Bezug auf einen Pfosten (32) des Gerüsts (28) des Schranks (10) vertikal zu zentrieren, wobei jeder Zentrierstift (108) in einem Positionierungsloch (81) einer Befestigungslasche (80) angeordnet ist.

2. Trägerkasten (60) nach Anspruch 1, wobei jede Platte (64) des Rahmens (62) einen in der montierten Konfiguration des Kastens (60) im Gerüst (28) des elektrischen Schranks (10) horizontalen Hauptschirm (74) und einen zum Hauptschirm (74) senkrechten und zum Boden (66) des Rahmens parallelen Rand (76) umfasst, und wobei der Boden des Rahmens an den Rändern der Platten befestigt ist.

3. Trägerkasten (60) nach einem der vorhergehenden Ansprüche, wobei jede horizontale Platte (64) des Rahmens (62) Nasen (84) umfasst, die zwei Positionierungsführungen (86) bilden, wobei jede Positionierungsführung derart ausgelegt ist, eine vertikale Wand (68A, 68B) des Rahmens in Bezug auf die horizontale Platte, die diese Positionierungsführung umfasst, zu positionieren.

4. Trägerkasten (60) nach einem der vorhergehenden Ansprüche, wobei der Boden (66) des Rahmens (62) mindestens zwei Kerben (90) umfasst, wobei jede Kerbe dazu ausgelegt ist, eine vertikale Wand (68A, 68B) des Rahmens in Bezug auf den Boden zu positionieren.

5. Elektrischer Anschlussschrank (10), umfassend:
- ein Gerüst (28), wobei das Gerüst eine im Wesentlichen parallelepipedische Form hat und vertikale Pfosten (32) umfasst;
- mindestens einen Trägerkasten (60) nach einem der Ansprüche 1 bis 4, und
- mindestens ein Funktionselement (17), darunter mindestens einen Kontroll-Steuerungs-Einschub (42), wobei jedes Funktionselement (17) in einem Trägerkasten (60) angebracht ist und jeder Kontroll-Steuerungs-Einschub in einem Paar (70) Führungsschienen (72) eines Kastens translatorisch beweglich ist.

6. Elektrischer Anschlussschrank (10) nach Anspruch 5, wobei die in einem Trägerkasten (60) angebrachten Funktionselemente (17) mindestens umfassen:
- mindestens einen Kontroll-Steuerungs-Einschub (42),
- eine Schutzeinheit (44), wobei die Schutzeinheit allen im Kasten (60) angebrachten Kontroll-Steuerungs-Einschüben (42) gemeinsam ist, alle Kontroll-Steuerungs-Einschübe mit elektrischer Energie versorgt und alle Kontroll-Steuerungs-Einschübe elektrisch schützt, wobei die Schutzeinheit an einer vertikalen Wand (68A) des Rahmens (62) des Kastens (60) befestigt ist und die Schiene (72) jedes Schienenpaars (70), die dieser vertikalen Wand (68A) zugeordnet ist, trägt,
- einen Computerbusabschnitt (48), der dazu ausgelegt ist, alle Kontroll-Steuerungs-Einschübe des Kastens mit einem Industriecomputer (26) zu verbinden, und
- mehrere Anschlussmodule (46), insbesondere so viele Anschlussmodule wie Kontroll-Steuerungs-Einschübe, wobei jedes Anschlussmodul (46) dazu ausgelegt ist, einen Kontroll-Steuerungs-Einschub mit einer elektrischen Last (14) elektrisch zu verbinden.

7. Verfahren zum Zusammenbauen eines elektrischen Anschlussschranks (10), das mindestens Phasen umfasst, die darin bestehen:
- Zusammenbauen eines Trägerkastens (60) nach einem der Ansprüche 1 bis 4 auf dem Gerüst (28) einer Säule (16) zwischen vertikalen Pfosten (32); und
- Ausstatten des in der Säule platzierten Kastens mit Funktionselementen (17).

## Claims

1. Support box (60) supporting functional elements (17) within the frame (28) of an electrical connection enclosure (10), this box comprising:
- at least one pair (70) of rails (72) for guiding a monitoring-control plug-in unit (42) forming a functional element (17) in translation;
- a parallelepipedal framework (62) comprising:
∘ two horizontal plates (64) in a mounted configuration of the box (60) in the frame (28);
∘ a back (66) that is perpendicular to the horizontal plates (64) and vertical in the mounted configuration of the box in the frame; and
∘ two walls (68A, 68B) that are vertical in the mounted configuration of the box in the frame and that each support a rail (72) of each pair of rails (70),
- members (80, 102) for fastening the framework (62) to the frame (28),
**characterized in that**
- the members for fastening the framework (62) to the frame (28) of the electrical enclosure (10) comprise fastening lugs (80) that are elastically deformable and integral with the horizontal plates (64).
- the members for fastening the framework (62) to the frame (28) of the electrical enclosure (10) comprise elastically deformable load absorbing lugs (102), that are integral with the vertical walls (68A, 68B).
- the support box (60) further comprises at least one centring pin (108), configured to vertically centre the box (60) with respect to a post (32) of the frame (28) of the enclosure (10), each centring pin (108) being arranged in a positioning hole (81) of a fastening lug (80).

2. Support box (60) according to claim 1, wherein each plate (64) of the framework (62) comprises a main web (74), horizontal in the mounted configuration of the box (60) in the frame (28) of the electrical enclosure (10), and a border (76), perpendicular to the main web (74) and parallel to the back (66) of the framework, and wherein the back of the framework is fastened to the borders of the plates.

3. Support box (60) according to any one of the preceding claims, wherein each horizontal plate (64) of the framework (62) comprises tabs (84) forming two positioning guides (86), each positioning guide being configured to position a vertical wall (68A, 68B) of the framework with respect to the horizontal plate comprising this positioning guide.

4. Support box (60) according to any one of the preceding claims, wherein the back (66) of the framework (62) comprises at least two notches (90), each notch being configured to position a vertical wall (68A, 68B) of the framework with respect to the back.

5. Electrical connection enclosure (10) comprising:
- a frame (28), the frame being of overall parallelepipedal form and comprising vertical posts (32);
- at least one support box (60) according to any one of Claims 1 to 4; and
- at least one functional element (17), including at least one monitoring-control plug-in unit (42), each functional element (17) being mounted in a support box (60) and each monitoring-control plug-in unit being movable in translation in a pair (70) of guiding rails (72) of a box.

6. Electrical connection enclosure (10) according to Claim 5, wherein the functional elements (17) mounted in a support box (60) comprise at least:
- at least one monitoring-control plug-in unit (42),
- a protection unit (44), the protection unit being common to all the monitoring-control plug-in units (42) mounted in the box (60), supplying electrical power to all the monitoring-control plug-in units and electrically protecting all the monitoring-control plug-in units, the protection unit being fastened to a vertical wall (68A) of the framework (62) of the box (60) and supporting the rail (72) of each pair of rails (70) associated with this vertical wall (68A),
- a computer bus section (48) configured to connect all the monitoring-control plug-in units of the box to an industrial computer (26), and
- several connection modules (46), notably as many connection modules as there are monitoring-control plug-in units, each connection module (46) being configured to electrically connect a monitoring-control plug-in unit to an electrical load (14).

7. Method for assembling an electrical connection enclosure (10), comprising at least phases consisting in:
- assembling a support box (60) according to one of Claims 1 to 4 on the frame (28) of a column (16), between vertical posts (32); and
- equipping the box, in place in the column, with functional elements (17).
